(19) Europäisches Patentamt

European Patent Office

Office européen des brevets

(11) EP 1 701 380 A2

(12) **EUROPEAN PATENT APPLICATION**

(43) Date of publication:
**13.09.2006 Bulletin 2006/37**

(51) Int Cl.:
**H01L 23/373** (2006.01)    **H01L 21/48** (2006.01)

(21) Application number: **06002874.3**

(22) Date of filing: **13.02.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **08.03.2005 JP 2005063638**

(71) Applicant: **HITACHI, LTD.**
**Chiyoda-ku**
**Tokyo 100-8280 (JP)**

(72) Inventors:
• **Hashimoto, Keita**
**Hitachinaka-shi**
**Ibaraki 312-0063 (JP)**

• **Suwa, Tokihito**
**Hitachinaka-shi**
**Ibaraki 312-0062 (JP)**
• **Seto, Sadashi**
**Hitachinaka-shi**
**Ibaraki 312-0063 (JP)**
• **Shigeta, Satoru**
**Hitachinaka-shi**
**Ibaraki 312-0063 (JP)**
• **Fujino, Shinichi**
**Mito-shi**
**Ibaraki 312-0912 (JP)**

(74) Representative: **Beetz & Partner**
**Steinsdorfstrasse 10**
**80538 München (DE)**

(54) **Semiconductor power module**

(57) A semiconductor power module has insulative substrate (21) which is configured with a metal wiring pattern (22) formed on an upper first surface thereof, a metal conductor (23) formed on a rear face, opposite the first surface and an insulative layer (21) between the metal wiring pattern and the metal conductor (23). A semiconductor chip (1) is joined to the metal wiring pattern (22) formed on the first surface of the insulative substrate (21), using Pb-free solder with a low melting point. A heat sink (4) is bonded to the metal conductor (23) formed on the other surface of the insulative substrate (21), using a highly heat conductive adhesive (5) having a thermal conductivity of 2 W/(mK) or more.

FIG.1

EP 1 701 380 A2

**Description**

Background of the Invention

The present invention relates to a semiconductor power module structure suitable for mounting of a semiconductor power switching device such as IGBT, MOS-FET, or SIT.

A semiconductor power module used, for example, for motor control and power conversion uses solder with a high melting point and solder with a low melting point therein as disclosed in Fig. 9 of Japanese Patent Laid-open No. 2001-110985. That is, a semiconductor power switching device and a metal wiring pattern formed on one surface of an insulative substrate are joined by solder with a high melting point first, and a metal conductor formed on the other surface of an insulative substrate and a metal base are joined by solder with a low melting point. Further, the metal base is pressed in good contact with a heat sink as a heat dissipation member, by way of grease with good thermal conductivity.

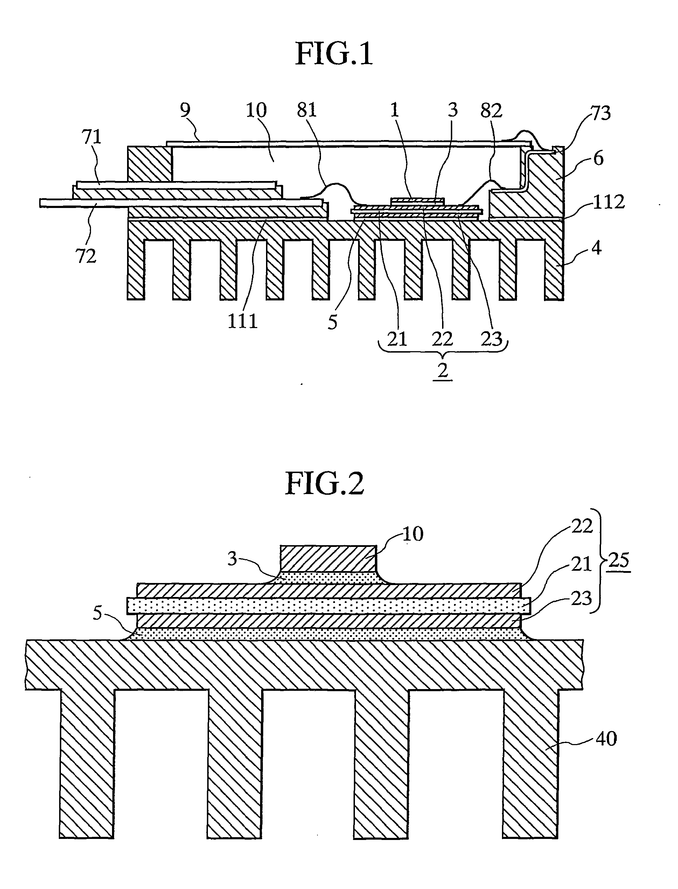

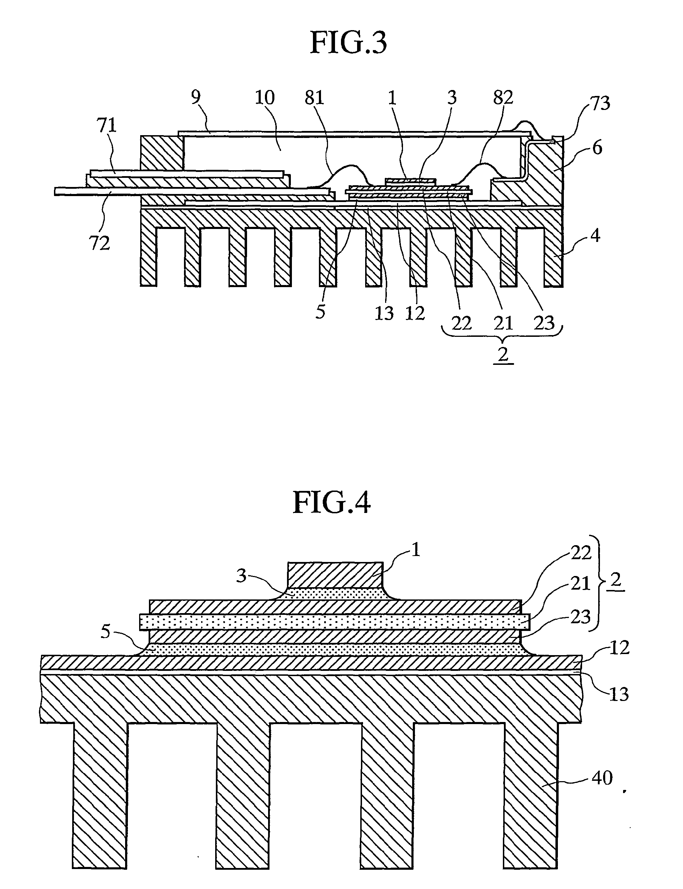

Japanese Patent Laid-open No. 7-7027 discloses, in Figs. 2 and 4, a technique of joining a semiconductor chip with a metal wiring pattern on one surface of an aluminum insulative substrate by using Pb-incorporated solder, and bonding the other surface of the insulative substrate directly to a heat sink (a metal back plate) with a heat conductive adhesive. In Fig. 4, recognizing the importance to the heat dissipation from the semiconductor chip in the lateral direction, a thick film of a metal conductive material is formed on the other surface of the insulative substrate just below the semiconductor chip to reduce the thickness of the heat conductive adhesive accordingly.

In recent years, it has been desired to decrease the use of substances that significantly affect the environment, such as Pb (lead), Cd (cadmium), and Cr (chromium). Since the solder used for mounting electronic parts contains much Pb, it has been gradually replaced with the so-called Pb-free solder which is substantially free of Pb. Various types of solder with a relatively low melting point have been put to practical use, including, for example, Pb-free solder comprising 3.5% by weight of Ag (silver), 1.5% by weight of Cu (copper) and the balance of Sn (Tin). However, Pb-free solder with a high melting point now available for practical use comprises 80% by weight of Au (gold) with the balance being Sn, and is extremely expensive due to its high Au content. Accordingly, there has been a delay in attaining Pb-free construction of a semiconductor power module, due to concern regarding the resulting cost increase.

The technique disclosed in Fig. 9 of JP 2001-110985 requires two different soldering steps, conducted at a high melting point respectively, and at a low melting point, and cannot provide Pb-free constitution. Further complication of the manufacturing step also creates an additional economic problem.

On the other hand, the technique disclosed in Fig. 2 or 4 of JP Laid-open patent document 7-7027 is sensitive to heat cycle-induced stress creating reliability problems, and cannot provide a semiconductor power module with a high current capacity of 100 [A] or more.

Summary of the Invention

It is an object of the present invention to provide a semiconductor power module having excellent economical efficiency due to the simplification of manufacturing steps and high reliability relative to heat cycles.

It is another object of the present invention is to provide a semiconductor power module of a high current capacity capable of providing Pb-free constitution.

According to the invention, an electrically insulative substrate is used in which a metal wiring pattern is formed on one surface (referred to herein, solely for identification, as the "upper surface") of an insulative layer and a metal conductor is provided on the other surface (referred to herein, for identification as the "rear face") of the insulative layer. The metal wiring pattern adapted to mount a semiconductor chip is patterned by etching in accordance with the requirement of wiring after being formed substantially over the entire surface of the insulative substrate. In order to suppress warping due to heat expansion between the upper surface and the rear face, and to suppress distortion caused in the semiconductor chip and in the solder below the it due to thermal effects, the metal conductor provided on the rear face of the insulative layer must be formed over substantially the entire surface of the rear face. Also, the thickness of the metal conductor should be no greater than the thickness of the metal wiring pattern formed on one surface of the insulative layer. For example, the strength is balanced between the upper surface and the rearface by making the thickness of the metal wiring pattern formed on the upper surface 0.3 (mm) and the thickness of the metal conductor provided on the rear face 0.2 (mm), thereby providing a high resistance to the heat cycle-induced stress.

Further, the metal wiring pattern and the metal conductor sandwiching the insulative layer of the insulative substrate therebetween is preferably Ag, Cu, Al or a metal containing them.

According to the invention, the metal wiring pattern and the semiconductor chip are joined together on the upper surface of the insulative substrate, and the metal conductor provided on the rear face is thermally connected to a heat sink by way of a highly heat conductive adhesive.

In the insulative substrate, it is preferred that the metal conductor provided on the rear face of the insulative layer be formed over substantially the entirety of the rear face and that the thickness of the metal conductor be no greater than the thickness of the metal wiring pattern formed on the upper surface of the insulative layer.

The solder used for joining the metal wiring pattern provided on the upper surface of the insulative substrate and the semiconductor chip is preferably solder with a low melting point of 240°C or lower and, particularly, PbFe solder.

Further, the metal conductor provided on the rear face of the insulative substrate can be bonded to a metal base containing copper, by a highly heat conductive adhesive, connected thermally by way of heat conductive grease to a heat sink.

According to the invention, the metal wiring pattern of the insulative substrate and the semiconductor chip are joined by solder with a low melting point on the rear face of the insulative substrate, and the metal conductor of the insulative substrate and the heat sink are directly bonded together using a highly heat conductive adhesive. In this case, the solder with a low melting point is preferably Pb-free solder.

In a further preferred embodiment of the invention, the heat conductive adhesive used to join the metal conductor provided on the rear face of the insulative substrate to the metal base or heat sink (heat dissipation member) is defined as 2 W/(mk) or more.

According to a preferred embodiment of the invention, the heat cycle-induced stress to the solder below the semiconductor chip can be decreased to ensure high reliability, by the combination of an insulative substrate having metal conductor on both the surfaces thereof and the highly conducting adhesive. Further, it is possible to provide an economically highly efficient semiconductor power module having a high current capacity, by simplifying the manufacturing step using a single solder.

Further, according to a preferred embodiment of the invention, a single type of solder may be used for the semiconductor power module between the metal wiring pattern of the insulative substrate and the power semiconductor chip; that is, it is not necessary to use two different kinds of solder, with a high melting point and with a low melting point. This enables the use of solder with a low melting point and, particularly, Pb-free solder which was otherwise difficult to apply to the existing power module, thereby attaining the Pb-free constitution in the semiconductor power module having a high current capacity.

Further, according to another preferred embodiment of the invention, the metal base can be saved to decrease the thickness and weight of the semiconductor power module having a high current capacity, by joining the metal conductor of the insulative substrate and the heat sink (heat dissipation member) directly by a heat conductive adhesive. Further, the heat dissipation from the semiconductor chip to the heat sink can be improved the production cost can be decreased further, while simplifying the structure.

Furthermore, according to another preferred embodiment of the invention, the thermal resistance from the semiconductor chip to the heat sink (heat dissipation member) can be suppressed to a level less than that in the existing power module structure by using a highly heat conductive adhesive with a thermal conductivity of 2 W/(mK) or more.

Other objects and the features of the invention will become apparent in the embodiments to be described below.

Brief Description of the Drawings

Fig. 1 is a cross-sectional view of a semiconductor power module according to a first embodiment of the invention;

Fig. 2 is an enlarged detail view of a main portion of the module in Fig. 1;

Fig. 3 is a cross-sectional view of a semiconductor power module according to a second embodiment of the invention;

Fig. 4 is an enlarged detail view of a main portion of the module in Fig. 3;

Fig. 5 is a cross-sectional view illustrating a main portion of a comparative embodiment of a semiconductor power module, for comparison of thermal resistance to thermal conductivity of a heat conductive adhesive with the first embodiment of the invention;

Fig. 6 is a diagram showing the ratio of thermal resistance of the heat conductive adhesive to the thermal conductivity for a semiconductor power module for a first example of the first embodiment in Fig. 1 of the invention and a first comparative example of the structure shown in Fig. 5;

Fig. 7 is a diagram showing the ratio of thermal resistance of the heat conductive adhesive to the thermal conductivity for a semiconductor power module for a second example of the first embodiment in Fig. 1 of the invention and a second comparative example of the structure shown in Fig. 5; and

Fig. 8 is a diagram showing the ratio of thermal resistance of the heat conductive adhesive to the thermal conductivity for a semiconductor power module of a third example of the second embodiment in Fig. 1 of the invention and a third comparative example of the structure shown in Fig. 5.

Detailed Description of the Preferred Embodiments

First Embodiment

Fig. 1 is a cross-sectional structural view of a semiconductor power module according to a first embodiment of the present invention and Fig. 2 is an enlarged view of a main portion in Fig. 1.

A MOS-FET chip 1 as a semiconductor power switching device is mounted on an insulative substrate 2, by means of solder 3. The insulative substrate 2 has a metal wiring pattern 22 formed on the upper surface of an insulative layer 21 made of silicon nitride, and a metal conductor 23 formed on the opposite surface (rear face) thereof so that the insulative layer is between the metal wiring pattern 22 and the metal conductor 23. The semiconductor chip 1 is bonded on the metal wiring pattern 22, using Pb-free solder 3 with a low melting point of 250°C or lower. The insulative substrate 2 mounted with the semiconductor chip 1, is mounted on a heat sink 4 made of aluminum (Al). That is, the insulative substrate 2 is bonded to the heat sink 4, via the metal conductor 23 on the rear face thereof, using a highly heat conductive adhesive 5 that has a thermal conductivity of 2 W/(mK) or more.

A resin case 6 is attached to the heat sink 4 by silicon adhesives 111 and 112, and copper bus bars 71 to 73 are insert molded to the resin case 6. The metal wiring pattern 22 joined with the semiconductor chip 1 is connected via bonding wires 81, 82 to the copper bus bars 72 and 73, respectively. The upper end of the case 6 is covered with a control substrate 9 of the power module and a silicon gel is filled as a sealant in the case 6.

As described above, the insulative substrate 2 includes the insulative layer 21 made of silicon nitride, the metal wiring pattern 22 formed on the upper surface thereof, and a metal conductor 23 formed on the rear face, such that the insulative layer 21 is between the insulative layer 21 and the metal conductor 23. The metal wiring pattern 22 and the metal conductor 23 are each formed of a metal of Ag, Cu or Al, or a metal containing them. The metal wiring 22 on which the semiconductor chip 1 is mounted is formed substantially over the entire surface of the insulative layer 21 and then patterned by etching in accordance with the requirement of the wiring.

The insulative substrate 2 is formed into a structure that is resistant to heat cycles in actual use, and that suppresses strain in the solder 3 by balancing heat expansion between the upper surface and the rear face. For this purpose, the metal conductor 23 on the rear face of the insulative substrate 2 is formed substantially over the entire surface of the insulative layer 21, to a thickness less than the metal wiring pattern 22 on the upper surface of the insulative substrate 2. That is, because the metal wiring pattern 22 is patterned by etching in accordance with the required wiring, it is assumed that it has a strength about 2/3 that of the metal conductor formed over the entire rear face. According, if the thickness of the metal wiring pattern 22 is 0.3 mm, the thickness of the metal conductor 23 is made to about 0.2 mm, or 2/3 of the thickness of the metal wiring pattern 22, thereby making it possible to balance the strength of the upper surface and the rear face and to provide a structure resistant to heat cycles. This can reduce the heat cycle-induced stress applied to the solder 3, improving reliability. For the reason described above, the thickness of the metal conductor 23 on the rear face of the heat insulative substrate 2 should be less than the thickness of the metal wiring pattern on one surface.

According to the first embodiment, the heat cycle-induced stress applied to the solder 3 can be decreased to ensure a high reliability by the combination of the insulative substrate 2 having the metal conductors 22 and 23 well balanced between both surfaces, and the highly conductive adhesive 5.

Further, it may suffice to use only one kind of the solder 3, and it is not necessary to use different kinds of solders that have different melting points. It is thus possible to simplify the manufacturing steps to provide a semiconductor power module with large current capacity and excellent economic efficiency. Accordingly, the Pb-free solder 3, which would otherwise be difficult to apply in the existing power module, can be used.

Further, by directly joining the metal conductor 23 of the insulative substrate 2 to the heat sink 4 using a highly heat conductive adhesive 5, the existing metal base can be used. Moreover, both the thickness and the weight of the semiconductor power module of high current capacity can be decreased, and the production cost can be reduced, while simplifying the structure. In addition, the heat dissipation from the semiconductor chip to the heat sink 4 can be improved. In particular, by the use of the highly heat conductive adhesive 5 having a thermal conductivity of 2 W/(mK) or more, the thermal resistance from the semiconductor chip 1 to the heat sink 4 can be lowered compared with the existing structure using the metal base.

In the first embodiment, while silicon nitride is used for the insulative layer 21 in the insulative substrate 2, other insulative material may also be used. Further, while each of the bonding wires (aluminum wiring) 81 and 82 is illustrated as a single wire, the actual number of wires can differ depending on the specification of the power module and the wire diameter. Further, while a structure is shown for the case of a MOS-FET as the semiconductor power switching device, it will be apparent that the invention is applicable also to any semiconductor switching devices, including IGBT, SIT or a combination of them with diodes in inversed-parallel arrangement.

Second Embodiment

Fig. 3 is a cross-sectional structural view of a semiconductor power module according to a second embodiment of the invention, and Fig. 4 is an enlarged view of a main portion of Fig. 3.

In Figs. 3 and 4, components having the same functions as those in Figs. 1 and 2 carry the same reference numerals for which duplicate explanation is to be omitted. The second embodiment differs from the first embodiment in Figs. 1 and 2 in that a metal base 12 made of copper, and heat conductive grease 13, are interposed between the insulative substrate 2 and the heat sink 4. An insulative substrate 2 is bonded by using a highly heat conductive adhesive 5 to the surface of the copper base 12. Then, as in the first embodiment, a semiconductor chip 1 is joined on a metal wiring pattern 22 on one surface of the insulative substrate 2 with low melting Pb-free solder 3.

The copper base 12 mounted with the semiconductor chip 1 is secured by way of a casing 6 to the heat sink 4 with the grease 13 being put therebetween.

Like the first embodiment, in the second embodiment, the heat cycle-induced stress applied to the solder 3 can be decreased to ensure high reliability by the combination of the insulative substrate 2 having the metal conductors 22 and 23 that are well balanced between both surfaces, and the highly conductive adhesive 5.

Further, it may suffice to use only one kind of the solder 3, and it is not necessary to use different kinds of solders that have different melting points. It is thus possible to simplify the manufacturing steps, and to provide a semiconductor power module of large current capacity and excellent economic efficiency. Accordingly, the Pb-free solder 3, which is difficult to apply in the existing power module, can be used.

Further, since the insulative substrate 2 and the semiconductor chip 1 can be fabricated on the copper base 12, the manufacturing steps can be simplified to provide a semiconductor power module having a high current capacity and excellent economic efficiency.

The thermal resistance from the lower surface of the semiconductor chip 1 to the base of the fin of the heat sink 4 can be calculated. Heat generation of the semiconductor chip 1 is calculated assuming that the heat is conducted from the lower surface at an angle of 45°.

First Example

It is assumed that the size of the semiconductor chip 1 is 7.7 mm x 7.7 mm x 0.2 mm, the thickness of the Pb-free solder 3 is 0.11 mm, and the thermal conductivity thereof is 30 W/(mK). Further, it is also assumed that the material of the metal wiring pattern 22 on one surface of the insulative substrate 2 is Cu, the thickness is 0.4 mm, and the thermal conductivity is 380 W/(mK). It is further assumed that the material of the insulative layer 21 of the insulative substrate 2 is silicon nitride, its thickness is 0.32 mm, its thermal conductivity is 62 W/(mK); and on the other hand that the material of the metal conductor 23 on the other surface of the insulative substrate 2 is Cu, its thickness is 0.4 mm and its thermal conductivity is 380 W/(mK). It is further assumed that the thickness of the highly heat conductive adhesive 5 is 0.1 mm, the distance from the bonded surface of the heat sink 4 to the base of the fin is 8 mm, and the thermal conductivity is 151 W/(mK).

Based on the values described above, the thermal resistance of each member is calculated. Assuming the thermal conductivity of the $i_{th}$ member as $Ci$, the thickness as $ti$, and the average cross sectional area as $Si$, the thermal resistance $Rthi$ of the $i_{th}$ member is given by the following equation.

$$Rthi = ti/(Si \cdot Ci)$$

Since the thermal resistance $Rth$ from the lower surface of the semiconductor chip 1 to the base of the fin of the heat sink 4 is the sum of the thermal resistance $Rthi$ of the members, it is determined according to the following formula.

$$Rth = \Sigma\ Rthi$$

Comparative Embodiment

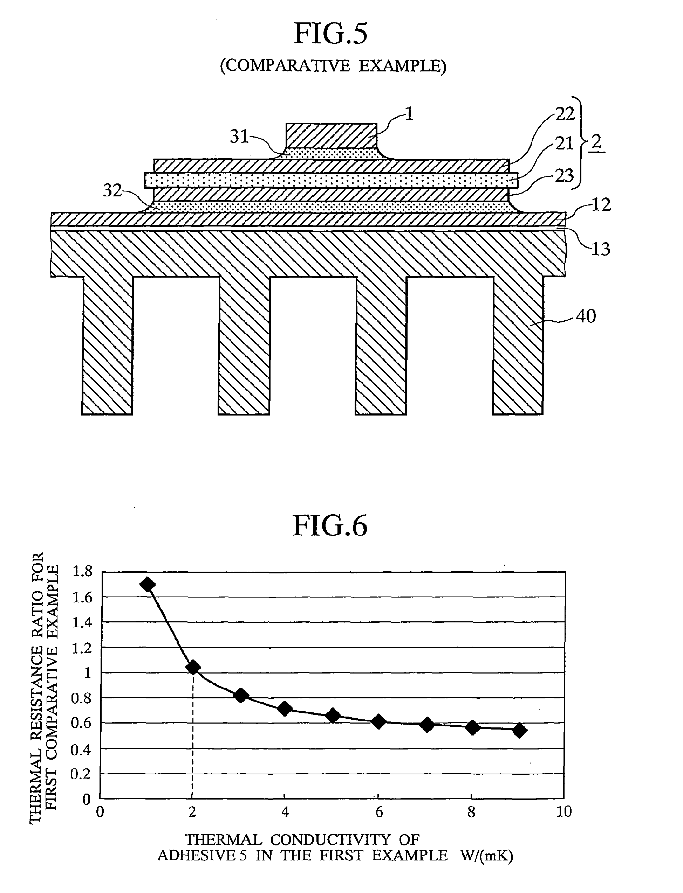

Fig. 5 is a structural view for a comparative embodiment for demonstrating the effect of the semiconductor power module according to the invention. As an insulative substrate, as in the invention, an insulative substrate 2 has metal wiring pattern 22 is formed on the upper surface and a metal conductor 23 formed on its rear face. This differs from the embodiments of the present invention, first in that a semiconductor chip 1 and the metal wiring pattern 22 on one surface of the insulative substrate 2 are joined by Pb-incorporated solder 31 with a high melting point. In addition, the metal conductor 23 on the other surface of the insulative substrate 2 and a copper base 12 are joined by Pb-incorporated solder 32 with a low melting point. Reference 13 denotes heat conductive grease.

Thermal resistance from the lower surface of the semiconductor chip 1 to the base of the fin of a heat sink 4 in the structure of the comparative embodiment is calculated. In the same manner as in the first example, the heat generation of the semiconductor chip 1 is calculated such that heat is conducted from the lower surface thereof at an angle of 45°.

First Comparative Example

It is assumed that the size of the semiconductor chip 1 is 7.7 mm x 7.7 mm x 0.2 mm, the thickness of each of the Pb-incorporated solder 31 and 32.is 0.11 mm, and the thermal conductivity thereof is 30 W/(mK). Further, it is assumed that the thickness of the copper base 12 is 3 mm and the thermal conductivity is 380 W/(mK). It is further assumed that the thickness of the heat conductive grease 13 is 0.1 mm and the thermal conductivity is 1 W/(mK). It is further assumed that the material, value, and thermal conductivity of each of the other members are the same as those of the first example.

Based on the values described above, the thermal resistance Rth from the lower surface of the semiconductor chip 1 to the base of the fin of the heat sink can be calculated in the same manner as for the first example.

Fig. 6 shows the results of the thermal resistance of the power module calculated in the first example and the first comparative example. The abscissa represents the thermal conductivity of the highly heat conductive adhesive 5 in the first example, and the ordinate represents the thermal resistance ratio of the first example relative to that for the structure of the first comparative example at each thermal conductivity.

It can be seen from Fig. 6 that when the thermal conductivity of the highly heat conductive adhesive 5 is greater than about 2 W/(mK), the thermal resistance of the first example is reduced to a level less than that for the structure of the first comparative embodiment.

Second Example

In the power module of the first embodiment according to the invention in Figs. 1 and 2, the thermal resistance Rth from the lower surface of the semiconductor chip 1 to the base of the fin of the heat sink 4 is calculated for the case where the chip size of the semiconductor chip 1 is 9 mm x 9 mm x 0.2 mm. The material, thickness, and thermal conductivity of each of the other members, as well as the calculation method are the same as those of the first example.

Second Comparative Example

In the power module of the comparative example in Fig. 5, the thermal resistance Rth from the lower surface of the semiconductor chip 1 to the base of the fin of the heat sink 4 is calculated for the case where the chip size of the semiconductor chip 1 is 9 mm x 9 mm x 0.2 mm. The material, thickness, and thermal conductivity of each of the other members, as well as the calculation method are the same as those of the first example.

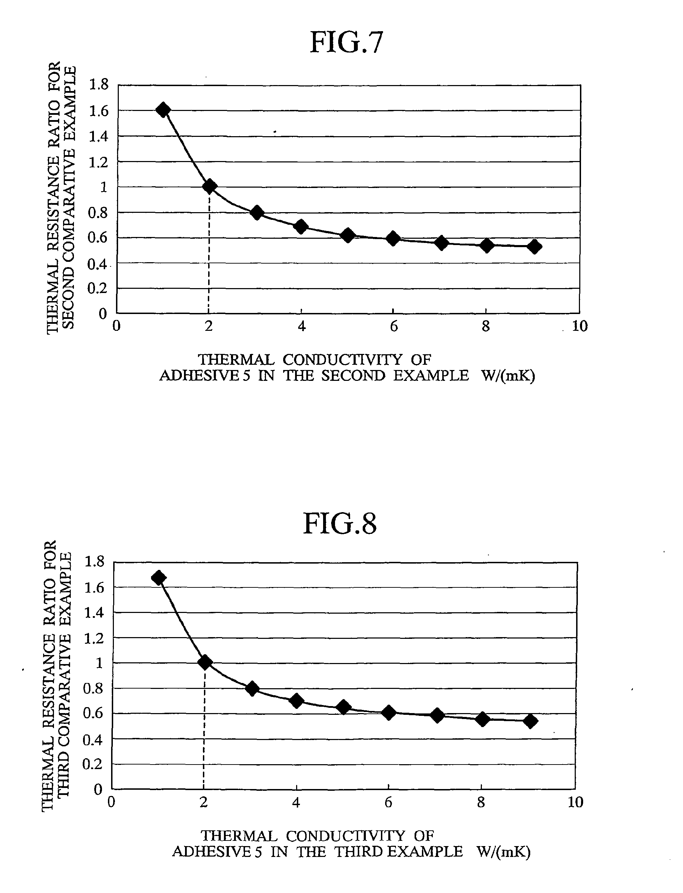

Fig. 7 shows the results of thermal resistance of the power module calculated in the second example and the second comparative example. The abscissa represents the thermal conductivity of the highly heat conductive adhesive 5 in the second example and the ordinate represents the thermal resistance ratio in the second example relative to the structure of the second comparative example at each thermal conductivity.

It can be seen from Fig. 7 that when the thermal conductivity of the highly heat conductive adhesive 5 is greater than about 2 W/(mK), the thermal resistance of the second example is lowered to a level less than that for the structure of the second comparative example.

Third Example

In the power module of the structure of the first embodiment according to the invention shown in Figs. 1 and 2, the thermal resistance Rth from the lower surface of the semiconductor chip 1 to the base of the fin of the heat sink 4 is calculated assuming the chip size of the semiconductor chip 1 as 7 mm × 9 mm × 0.2 mm. The material, thickness, and thermal conductivity of each of the materials as well as the calculation method are the same as those in the first example.

Third Comparative Example

In the power module of the structure of the comparative example in Fig. 5, the thermal resistance Rth from the lower surface of the semiconductor chip 1 to the base of the fin of the heat sink 4 is calculated for the case where the chip size of the semiconductor chip 1 is 7 mm x 9 mm x 0.2 mm. The material, thickness and thermal conductivity of each of the other members, as well as the calculation method are the same as those of the first example.

Fig. 8 shows the results of the thermal resistance of the power module calculated in the third example and the third comparative example. The abscissa represents the thermal conductivity of the highly heat conductive adhesive 5 in the third example, and the ordinate represents the thermal resistance ratio in the third example relative to the structure of the third comparative example at each thermal conductivity.

It can be seen from Fig. 8 that when the thermal conductivity of the highly heat conductive adhesive 5 is greater than about 2 W/(mK) or more, the thermal resistance of the third example is lowered to a level less than that for the structure of the third comparative example.

As described above, according to the first to third examples, the thermal resistance from the semiconductor chip 1 to the heat dissipation surface of the heat sink 4 can be reduced by using the highly heat conductive adhesive 5 for connection between the insulative substrate 2 (having the metal conductor layers 22 and 23 on both of its surfaces) and the heat sink 4. Further, Pb-free constitution of the semiconductor power module with the continuous rated current of 100 Ω thus becomes possible.

While the invention has been described in its preferred embodiments, it is to be understood that the words which have been used are words of description rather than limitation and that changes within the purview of the appended claims may be made without departing from the true scope and spirit of the invention in its broader aspects.

## Claims

1.   A semiconductor power module comprising:

   an electrically insulating substrate (2) formed by laminations comprising an insulating layer (21), a metal pattern (22) disposed on a first surface of the insulating layer, and a metal conductor (23) disposed on a second surface, opposite to the first surface, of the insulating layer (21);
   a power semiconductor chip (1) mounted on the insulating substrate (2) via solder (3) which connects electrically between the power semiconductor chip (1) and the metal pattern (22) of the insulating substrate (2); and
   a heat sink (4) bonded to the insulating substrate by at least an adhesive (5) which connects thermally between the heat sink (4) and the metal conductor (23).

2.   The semiconductor power module according to claim 1, wherein the solder (3) has a melting point that is no greater than 250°C.

3.   The semiconductor power module according to claim 1, wherein the solder (3) is Pb-free.

4.   The semiconductor power module according to claim 1, wherein:

   the metal conductor (23) is formed over substantially all of the second surface of the insulating layer (21); and
   the thickness of the metal conductor (23) is no greater than that of the metal pattern (22) formed on the first surface of the insulating layer (21).

5.   The semiconductor power module according to claim 1, wherein the metal conductor (23) and the heat sink (4) are directly bonded by the adhesive (5).

6.   The semiconductor power module according to claim 1, wherein a copper base (12) is disposed between said metal conductor and said heat sink (4).

7.   The semiconductor power module according to claim 1, wherein the adhesive (5) has a thermal conductivity of at least 2 W/(mK).

8.   The semiconductor power module according to claim 1, wherein the metal pattern (22) and the metal conductor (23) are formed from a material selected from the group consisting of Ag, Cu, Al, and a metal containing at least one of Ag, Cu and Al.

9.   The semiconductor power module according to claim 1, wherein continuous rated current of the power semiconductor module is at least 100A.

10. The semiconductor power module according to claim 1, further comprising:

   a resin case (6) attached to said heat sink (4);
   a bus bar (71, 72, 73) inserted into said resin case (6); and
   a bonding wire (81, 82) connecting between the metal pattern (22) and the bus bar (71, 72, 73).

11. The semiconductor power module according to claim 10, further comprising a control substrate (9) covering the upper end of said resin case (6).

12. The semiconductor power module according to claim 11, further comprising a silicon gel disposed inside of said resin case (6), wherein said power semiconductor chip (1) is filled with the silicon gel.

13. A semiconductor power module comprising:

   a heat sink (4);
   a metal base (12) disposed on said heat sink through heat conductive grease (13);
   an electrically insulating substrate (25) disposed on said metal base (12) through an adhesive (5), which substrate (25) is formed by laminations comprising an insulating layer (21), a metal pattern (22) disposed on a first surface of the insulating layer (21), and a metal conductor (23) disposed on a second surface, opposite to the first surface, of the insulating layer (21); and
   a power semiconductor chip (10) mounted on the insulating substrate (25) via solder (3) which connects electrically between the power semiconductor chip (10) and the metal pattern (22) of the insulating substrate (25).

14. The semiconductor power module according to claim 13, wherein:

   the solder (3) has a melting point no greater than 250°C; and
   the solder is Pb-free.

15. The semiconductor power module according to claim 13, wherein:

   said heat sink (4) contains aluminum; and
   said metal base (12) contains copper.

16. The semiconductor power module according to claim 13, further comprising:

   a resin case (6) attached to said heat sink (4);
   a bus bar (71, 72, 73) inserted into said resin case (6);
   a bonding wire (81, 82) connecting between the metal pattern (23) and the bus bar (71, 72, 73); and
   a control substrate (9) covering an upper end of said resin case (6).

17. The semiconductor power module according to claim 16, further comprising a silicon gel disposed inside of said resin case (6), wherein said power semiconductor chip (10) is filled with the silicon gel.

18. The semiconductor power module according to claim 13, wherein:

   the metal conductor (23) is formed over substantially the entire second surface of the insulating layer (21); and
   the thickness of the metal conductor (23) is no greater than that of the metal pattern (22) formed on the first surface of the insulating layer (21).

19. The semiconductor power module according to claim 13, wherein thermal conductivity of the highly heat conductive adhesive is at least 2 W/(mK).

20. The semiconductor power module according to claim 13, wherein a continuous rated current of the power semiconductor module is at least 100 A.

EP 1 701 380 A2

# FIG.1

# FIG.2

9

# FIG.3

# FIG.4

# FIG.5

## (COMPARATIVE EXAMPLE)

# FIG.6

THERMAL RESISTANCE RATIO FOR FIRST COMPARATIVE EXAMPLE

THERMAL CONDUCTIVITY OF
ADHESIVE 5 IN THE FIRST EXAMPLE W/(mK)

# FIG.7

Y-axis: THERMAL RESISTANCE RATIO FOR SECOND COMPARATIVE EXAMPLE

X-axis: THERMAL CONDUCTIVITY OF ADHESIVE 5 IN THE SECOND EXAMPLE W/(mK)

# FIG.8

Y-axis: THERMAL RESISTANCE RATIO FOR THIRD COMPARATIVE EXAMPLE

X-axis: THERMAL CONDUCTIVITY OF ADHESIVE 5 IN THE THIRD EXAMPLE W/(mK)

## REFERENCES CITED IN THE DESCRIPTION

### Patent documents cited in the description

- JP 2001110985 A
- JP 7007027 A